# EUROPÄISCHE PATENTSCHRIFT

(11) **EP 1 976 357 B1**
(45) Veröffentlichungstag und Bekanntmachung des Hinweises auf die Patenterteilung: **11.12.2013**
(21) Anmeldenummer: 08102796.3
(22) Anmeldetag: 20.03.2008
(51) Int. Cl.: H05K 5/02, H05K 5/06

(54) **Gehäuse für eine elektrische Schaltung und Verfahren zum Schließen eines entsprechenden Gehäuses**
Housing for an electric switch and method for sealing such a housing
Boîtier pour une commutation électrique et procédé de fermeture d'un boîtier correspondant

(30) Priorität: 29.03.2007 DE 102007016127
(43) Veröffentlichungstag der Anmeldung: 01.10.2008
(73) Patentinhaber: ROBERT BOSCH GMBH, 70442 Stuttgart (DE)
(72) Erfinder: Hessler, Thomas, 72805 Lichtenstein (DE); Ruf, Christoph, 72800 Eningen (DE); Koelle, Gerhard, 75446 Wiernsheim (DE); Jacob, Wolfgang, 72160 Horb (DE)

(56) Entgegenhaltungen:
- EP-A1- 0 659 041
- WO-A1-91/02685
- DE-A1- 19 803 358
- US-B1- 6 273 426

## Beschreibung

Die Erfindung betrifft ein Gehäuse für eine elektrische Schaltung, insbesondere für ein Steuergerät eines Fahrzeugs, mit mindestens einem, einen die Schaltung aufnehmenden Innenraum aufweisenden Gehäuseelement, das mindestens einen dem Schließen des Gehäuses dienenden Randbereich aufweist.

Ferner betrifft die Erfindung ein Verfahren zum Schließen eines Gehäuses für eine elektrische Schaltung, insbesondere für das Gehäuse eines Steuergeräts eines Fahrzeugs, wobei das Gehäuse einen die Schaltung aufnehmenden Innenraum aufweist und mindestens einen Randbereich besitzt.

### Stand der Technik

Gehäuse für elektrische Schaltungen sind im Stand der Technik bekannt. Insbesondere werden sie in Anwendungen für elektronische Steuerungen in Fahrzeugen, beispielsweise für Steuergeräte, eingesetzt. Die Gehäuse sind dabei als Aluminiumdruckguss- oder Blechgehäuse ausgebildet und bestehen meist aus zwei Gehäuseelementen, einem Gehäuseboden und einem Gehäusedeckel, die gemeinsam einen Innenraum aufweisen. Die Wandstärken dieser Gehäuseelemente sind an die mechanischen und/oder thermischen Anforderungen der Anwendung angepasst. Entsprechend dieser Anwendung werden bei Dichtheitsanforderungen an das Steuergerät Dichtstoffe aus Kunststoff in eine im Randbereich ausgebildete Nut eines der Gehäuseelemente eingebracht. Beide Gehäuseelemente werden nach der Bestückung mit der elektrischen Schaltung, insbesondere mit einer elektronischen Schaltung, miteinander verschraubt. Anschließend härtet der Dichtstoff aus. Ein Gehäuse mit einem großen Innenraum wird mit mindestens einem Druckausgleichselement (DAE) versehen. Dieses Druckausgleichselement besteht aus einer Membran, die für Flüssigkeiten undurchlässig ist, jedoch Gase passieren lässt. Um eine angemessene elektromagnetische Verträglichkeit (EMV) des Steuergeräts zu erreichen, werden an die dem Schließen dienenden Randbereiche Dichtigkeitsanforderungen bezüglich elektromagnetischer Strahlung gestellt. Im Reparaturfall des Steuergerätes fallen beim Zerlegen oder Öffnen beträchtliche Kosten durch erforderliche Neuteile oder Reinigungsprozesse an.

EP 0 659 041 offenbart ein Gehäuse nach dem Oberbegriff des Anspruchs 1.

### Offenbarung der Erfindung

Das erfindungsgemäße Gehäuse ist dadurch gekennzeichnet, dass der Randbereich des Gehäuses mit mindestens einer, ein Schließen des Gehäuses herbeiführenden Falzung versehen ist. Weist das Gehäuse nur ein einziges Gehäuseelement auf, so wird dieses in einem Bereich so geknickt, dass das Gehäuse mit seinem Randbereich in zwei Teilbereiche aufgeteilt wird, wobei die Teilbereiche des Randbereichs zumindest bereichsweise aneinander grenzen und mindestens einer der Teilbereiche mit mindestens einer ein Schließen des Gehäuses herbeiführenden Falzung versehen ist. Bei mehreren Gehäuseelementen ist mindestens einer der Randbereiche eines der Gehäuseelemente mit mindestens einer Falzung versehen. Zum Falzen weist der Randbereich eine hinreichend geringe Wandstärke und entsprechende Materialeigenschaften auf, die das Schließen des Gehäuses mit der herbeigeführten Falzung ermöglicht. Das Gehäuseelement ist vorzugsweise ein tiefgezogenes Blechteil, insbesondere aus Aluminium oder Weißblech. Bei diesem Gehäuse können Gehäuseelemente mit dünnerer Wandstärke verwendet werden als bei anders geschlossenen Gehäusen. Daher ist das durch die Falzung im Randbereich geschlossene Gehäuse ein kostengünstiges Gehäuse. Ihre mechanische Stabilität erhalten die tiefgezogenen Gehäuseelemente insbesondere durch eine gestreckte Textur des Metallgefüges. Bei dieser Technik kann Weißblech verwendet werden, das aus Gründen der elektromagnetischen Verträglichkeit dem Gehäuse aus Aluminiumblechteilen vorzuziehen ist. Das Gehäuse ist insbesondere mit mindestens einem Druckausgleichselement (DAE) versehen.

Weiterhin ist vorgesehen, dass mindestens zwei Gehäuseelemente jeweils mit mindestens einem Randbereich versehen sind, wobei die Randbereiche mindestens bereichsweise aneinander grenzen und mindestens einer der Randbereiche mit mindestens einer ein Schließen des Gehäuses herbeiführenden Falzung versehen ist. Dabei sind insbesondere zwei, als Gehäuseboden und Gehäusedeckel ausgebildete Gehäuseelemente vorgesehen. Ein Aneinandergrenzen der Randbereiche bedeutet hier nicht notwendigerweise ein direktes Aneinandergrenzen.

In der Erfindung ist vorgesehen, dass die Randbereiche mindestens bereichsweise direkt aneinander grenzen und/oder mindestens bereichsweise unter Zwischenschaltung mindestens eines Dichtelements aneinander grenzen. Das Dichtelement dichtet den Innenraum von der Umgebung des Gehäuses ab, insbesondere bezüglich Flüssigkeiten und/oder elektromagnetischer Strahlung. Dabei ist mindestens einer der Randbereiche mit mindestens einer das Schließen des Gehäuses herbeiführenden Falzung versehen.

Weiterhin ist vorgesehen, dass einer der Randbereiche um den anderen der Randbereiche zumindest bereichsweise zumindest einmal herumgefalzt ist. Durch das Herumfalzen des einen Randbereiches um den anderen Randbereich wird das Schließen des Gehäuses herbeigeführt. Vorzugsweise ist der eine Randbereich um den anderen der Randbereiche und das Dichtelement zumindest einmal herumgefalzt. Dabei liegt - bei Verwendung eines Dichtelements- das Dichtelement zwischen dem umgefalzten Teil des Randbereichs und dem anderen Randbereich oder dem gefalzten Teil des Randbereichs und dem anderen Randbereich.

Weiterhin ist vorgesehen, dass die Randbereiche mindestens bereichsweise mindestens einmal miteinander gefalzt sind. Dabei sind die Randbereiche mindestens bereichsweise direkt und/oder mindestens bereichsweise unter Zwischenschaltung mindestens eines Dichtelements miteinander gefalzt.

Insbesondere ist vorgesehen, dass die umgefalzten Randbereiche unterschiedlich lang ausgebildet sind. Die aneinander grenzenden Randbereiche erstrecken sich zum Beispiel vom Innenraum des Gehäuses weg, wobei einer der Randbereiche in dieser Erstreckungsrichtung länger ist als der andere. Dieser längere Randbereich wird anschließend insbesondere um den anderen der Randbereiche zumindest bereichsweise zumindest einmal herumgefalzt. Vorzugsweise werden anschließend die beiden Randbereiche mindestens bereichsweise mindestens einmal miteinander gefalzt.

Nach einer Weiterbildung der Erfindung ist vorgesehen, dass die Falzung als Rollung ausgebildet ist oder mindesten eine Rollung aufweist. Eine als Rollung ausgebildete Falzung wird insbesondere durch simultanes Einrollen erstellt. Dabei wird nach einem Aufsetzen der Gehäuseelemente aneinander das zusammengesetzte Gehäuse in eine Presse eingelegt. Beim Schließen der Presse werden beide Gehäuseelemente durch einen Federboden zusammengedrückt und fixiert. Anschließend wirkt ein zweites formgebendes Werkzeug zusammen, das in zu schließendem Bereich gleichzeitig den längeren Randbereich des einen Gehäuseelements einrollt und gegen die gegenüberliegende Seite des anderen Randbereichs drückt. Dies hat den Vorteil, dass das Werkzeug nur in einer Raumrichtung bewegt werden muss und dass durch das formgebende Werkzeug Störkonturen des Gehäuses aufgenommen werden können, ohne die Dichtheit des Gehäuses zu beeinflussen. Eine Rollung bietet den Vorteil einer umlaufenden metallischen Kontaktierung der Gehäuseelemente. Dadurch wird eine optimale EMV-Abschirmung der montierten elektrischen Schaltung (elektronischen Schaltung) erreicht.

Nach einer Weiterbildung der Erfindung ist vorgesehen, dass mindestens einer der Randbereiche federelastisch ausgebildet ist. Die Federelastizität dieses Randbereichs wird insbesondere durch die Form der Falzung erreicht. Ein federelastisches Ausbilden der Randbereiche ist insbesondere bei Aluminium- oder Weißblechteilen möglich.

Insbesondere ist vorgesehen, dass mindestens einer der Randbereiche unter Vorspannung den anderen Randbereich beaufschlagt, insbesondere mit Druck beaufschlagt. Durch diese Beaufschlagung wird das Gehäuse fest verschlossen. Eine zwischen den Randbereichen angeordnete Dichtung wird bei entsprechender Falzung ebenfalls beaufschlagt und dichtet den Innenraum des Gehäuses vollständig gegen die Umgebung des Gehäuses ab.

Weiterhin ist mit Vorteil vorgesehen, dass die elektrische Schaltung, insbesondere ein Substrat der elektrischen Schaltung, von mindestens einem Randbereich gehalten ist. Vorzugsweise wird die elektrische Schaltung zwischen den Randbereichen angeordnet, und durch die Beaufschlagung durch den anderen Randbereich gehalten.

Das erfindungsgemäße Verfahren ist dadurch gekennzeichnet, dass der Randbereich des Gehäuses zum Schließen des Gehäuses mindestens einmal gefalzt wird. Zum Falzen weist der Randbereich eine hinreichend geringe Wandstärke und entsprechende Materialeigenschaften auf, die das Schließen des Gehäuses mit der herbeigeführten Falzung ermöglicht. Das Gehäuseelement ist insbesondere ein Blechteil aus Aluminium oder Weißblech. Das Blechteil ist vorzugsweise ein tiefgezogenes Blechteil. Mit diesem Gehäuse können Gehäuseelemente mit dünnerer Wandstärke verwendet werden als bisher. Somit ist das durch die Falzung im Randbereich geschlossene Gehäuse ein kostengünstiges Gehäuse. Erforderliche, mechanische Stabilität erhalten die tiefgezogenen Gehäuseelemente insbesondere durch eine gestreckte Textur des Metallgefüges. Bei dieser Technik kann Weißblech verwendet werden, das aus Gründen der elektromagnetischen Verträglichkeit dem Gehäuse aus Aluminiumblechteilen vorzuziehen ist.

Weiterhin ist vorgesehen, dass mindestens zwei Gehäuseelemente jeweils mit mindestens einem Randbereich versehen sind, wobei die Randbereiche mindestens bereichsweise aneinander grenzen und mindestens einer der Randbereiche zum Schließen des Gehäuses gefalzt wird. Dabei sind insbesondere zwei, als Gehäuseboden und Gehäusedeckel ausgebildete Gehäuseelemente vorgesehen. Insbesondere ist vorgesehen, dass einer der Randbereiche um den anderen der Randbereiche zumindest bereichsweise zumindest einmal herumgefalzt wird. Die Falzung erfolgt vorzugsweise bereichsweise. Insbesondere wird der eine Randbereich um den anderen der Randbereiche und ein Dichtelement zumindest einmal herumgefalzt. Alternativ oder zusätzlich ist mit Vorteil vorgesehen, dass die Randbereiche mindestens bereichsweise mindestens einmal miteinander gefalzt werden.

### Kurze Beschreibung der Zeichnungen

Im Folgenden wird die Erfindung anhand von in den Zeichnungen dargestellten Ausführungsbeispielen näher erläutert. Es zeigen:
- Figur 1: eine Explosionsdarstellung eines Gehäuses für ein Steuergerät eines Fahrzeugs,
- Figur 2: das Gehäuse der Figur 1 in einer Schnittdarstellung,
- Figur 3: ein Gehäuse, dessen Gehäuseboden eine geprägte Mulde mit Kupfer-Inlay aufweist,
- Figur 4: eine Schnittdarstellung durch eine Gehäuse vor dem Schließen,
- Figur 5: das Gehäuse der Figur 4 mit einer Falzung zum Schließen,
- Figur 6: das Gehäuse der Figur 5 mit einer weiteren Falzung,
- Figur 7: ein Schließen eines Gehäuses durch Einrollen und
- Figur 8: eine durch als Rollung ausgebildete Falzung geschlossenes Gehäuse.

### Ausführungsform(en) der Erfindung

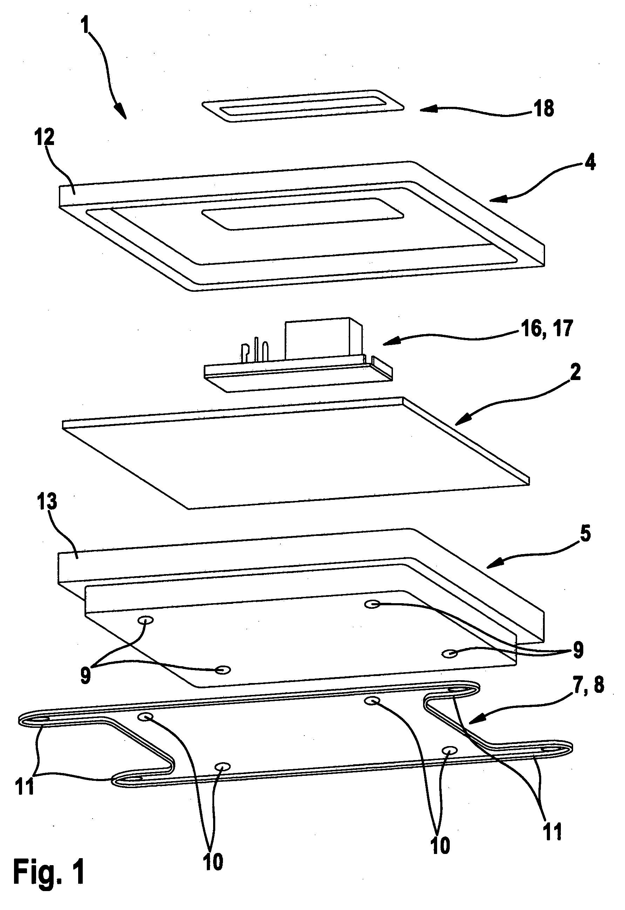

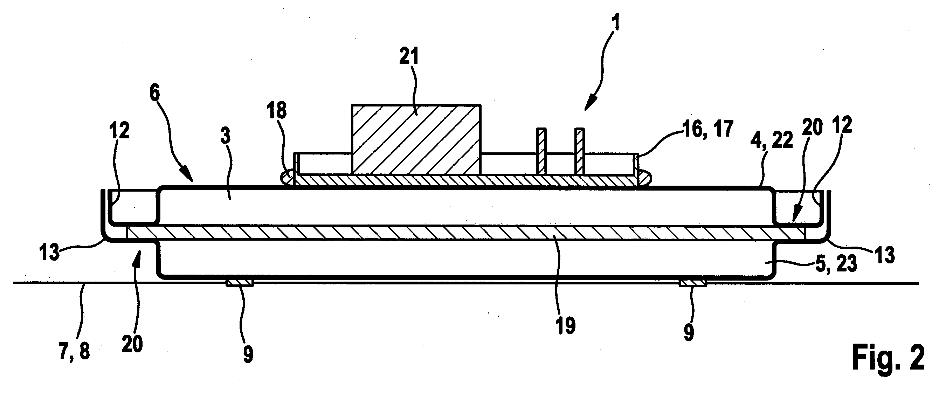

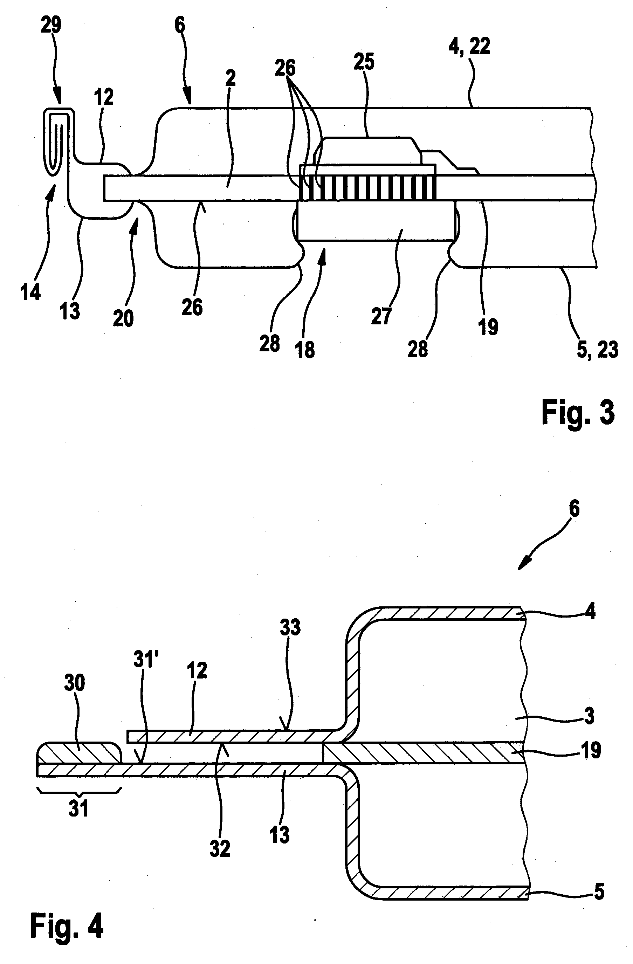

Die Figur 1 zeigt in einer Explosionsdarstellung ein Steuergerät 1 eines nicht dargestellten Fahrzeugs. Das Steuergerät 1 besteht aus einer elektrischen Schaltung 2, die in dem in der Figur 2 gezeigten Innenraum 3 eines zwei Gehäuseelemente 4, 5 aufweisenden Gehäuses 6 angeordnet ist. Das Gehäuseelement 4 ist als Gehäusedeckel und das Gehäuseelement 5 als Gehäuseboden des Gehäuses 6 ausgebildet. Zur Montage im Fahrzeug ist der Gehäuseboden 5 an einem als Montageblech 7 ausgebildeten Montageelement 8 befestigt. Die Befestigung erfolgt durch Nieten, wobei der Gehäuseboden 5 Nietdome 9 aufweist, die sich durch Durchbrüche 10 des Montageelements 8 erstrecken. Zur Montage an der Karosserie des Fahrzeugs weist das Montageblech 7 an gegenüberliegenden Kanten als Anschraubösen ausgebildete Befestigungselemente 11 auf. Beide Gehäuseelemente 4, 5 (Gehäusedeckel und Gehäuseboden) weisen jeweils einen umlaufenden Randbereich 12, 13 auf. Mindestens einer der Randbereiche 12, 13 wird zum Schließen des Gehäuses 6 mit einer zum Beispiel in der Figur 3 gezeigten Falzung 14 versehen. Im Gehäusedeckel 4 befindet sich ein Durchbruch 15 zur Aufnahme eines als Steckerleiste 16 ausgebildeten Anschlusselements 17. Zur Dichtung ist am Rand des Durchbruches 15 zwischen dem Gehäusedeckel 4 und dem Anschlusselement 17 eine Dichtung 18 angeordnet, die den Innenraum 3 des Gehäuses 6 gegen die Umgebung des Gehäuses 6 abdichtet.

Die Figur 2 zeigt das Gehäuse 6 der Figur 1 in einer Schnittdarstellung vor einem Schließen des Gehäuses 6 durch Falzung der Randbereiche 12, 13. Die Darstellung der Figur 2 zeigt dabei, dass die elektrische Schaltung 2 von den beiden Randbereichen 12, 13 der Gehäuseelemente 4, 5 an gegenüberliegenden Randbereichen seines als Platine ausgebildeten Substrates 19 in einer Klemmzone 20 gehalten wird. Die Steckerleiste 16 weist zum Anschluss eines nicht gezeigten Gegensteckers einen Stecker 21 auf. Die Gehäuseelemente 4, 5 sind als tiefgezogene Blechteile 22, 23 ausgebildet und bestehen aus Aluminium oder Weißblech. Sie weisen eine Wandstärke auf, die ein Schließen des Gehäuses 6 durch eine umlaufende Falzung 14 zumindest eines der Randbereiche 12, 13 ermöglichen.

Die Figur 3 zeigt ein durch eine umlaufende Falzung 14 der Randbereiche 12, 13 der Gehäuseelemente 4, 5 geschlossenes Gehäuse 6. Das Gehäuse 6 der Figur 3 entspricht im Wesentlichen dem Gehäuse 6 der Figur 2, sodass hier nur auf die Unterschiede eingegangen wird. Das als Gehäuseboden ausgebildete Gehäuseelement 5 weist eine Mulde 24 auf, die vorzugsweise geprägt ist. Durch diese Mulde 24 reicht das Blechteil 23 im Bereich eines elektronischen Bauelements 25 der elektrischen Schaltung 2 bis an die Unterseite 26 des Substrats 19 heran und kontaktiert die elektrische Schaltung 2 thermisch. Im Bereich des elektronischen Bauelements 25 weist das Substrat 19 mehrere, als Thermal-Vias ausgebildete Kanäle 26 auf, die zur Wärmeableitung vom Bauelement 25 bis zur Mulde 24 führen. In der Mulde 24 ist im Außenbereich des Gehäusebodens 5 ein als Kupfer-Inlay ausgebildetes Wärmereservoir 27 angeordnet, das eingepresst ist und zusätzlich durch Vorsprünge 28 am Rand der Mulde 24 gehalten wird. Das Wärmereservoir 27 dient zur Pufferung von Wärmepulsen der elektrischen Schaltung 2 beziehungsweise des Bauelements 25. Dabei sind Varianten möglich, bei denen die Wärmereservoirs auf der Innenseite oder auf der Außenseite des Gehäuses eingepresst werden. Alternativ zur Anordnung des Wärmereservoirs 27 in der Mulde 24 ist mindestens ein Wärmereservoir 27 vorgesehen, das zwischen der Mulde 24 des Gehäusebodens 5 und dem Substrat 19 oder in einer in der Mulde 24 ausgebildeten Gehäuseöffnung angeordnet ist, wobei das Wärmereservoir 27 immer in thermischen Kontakt mit der elektrischen Schaltung 2 steht. Das Wärmereservoir kann zum Beispiel in Kupfer ausgeführt sein oder aus Materialien wie Aluminium oder Stahl bestehen.

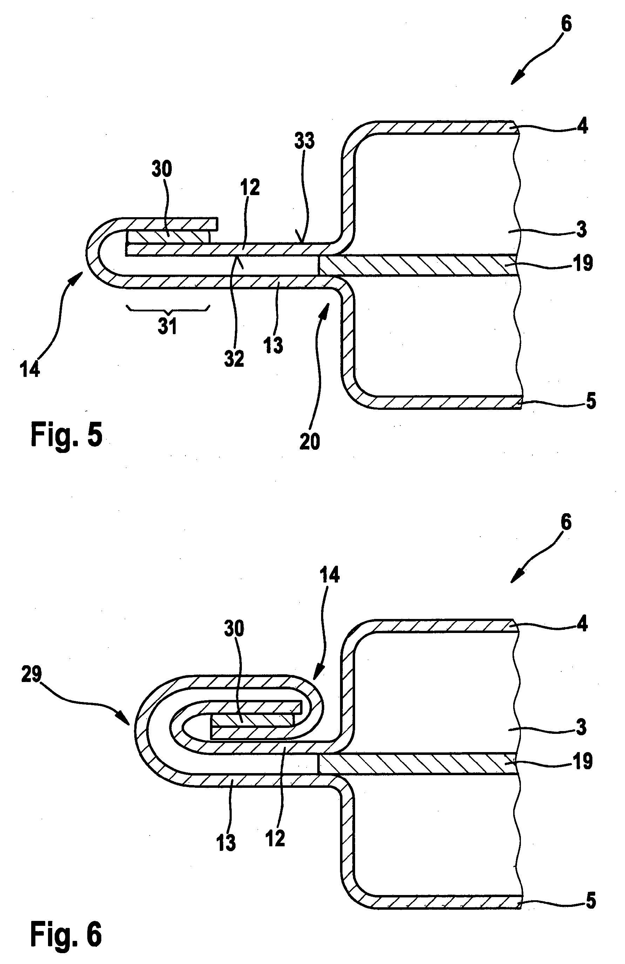

Das Gehäuse der Figur 3 ist durch eine umlaufende Falzung 14 geschlossen. Dazu sind die aneinander grenzenden Randbereiche 12, 13 zweimal miteinander gefalzt, sodass die Falzung 14 und eine zweite Falzung 29 entstehen. Beide Falzungen 14, 29 sind im Beispiel der Figur 3 umlaufende Falzungen 14, 29. Dabei sind die Randbereiche - wie in den Figuren 2 und 3 - direkt oder unter Zwischenschaltung mindestens eines Dichtelements 30 aneinander grenzend (siehe Figuren 5 und 6) ausgebildet.

Die Figur 4 zeigt das Schließen des Gehäuses 6 für ein Ausführungsbeispiel im Detail. Dazu weist das Gehäuse einen Gehäusedeckel 4 und einen Gehäuseboden 5 (Gehäuseelemente 4, 5) auf, die je einen umlaufenden Randbereich 12, 13 aufweisen. Der Randbereich 13 des Gehäusebodens 5 ist dabei länger ausgebildet als der Randbereich 12 des Gehäusedeckels 4. Der Teilbereich 31 des Randbereichs 13, der die zusätzliche Länge des Randbereichs 13 gegenüber dem Randbereich 12 ausmacht, ist auf seiner dem Randbereich 12 zugewandten Seite 31' mit dem Dichtelement 30 versehen. Zum Schließen des Gehäuses 6 wird der Randbereich 13 des Gehäusebodens 5 - zumindest bereichsweise - einmal um den Randbereich 12 des Gehäuseelements 4 herumgefalzt. Es entsteht die in Figur 5 gezeigte Falzung 14, bei dem die Randbereiche 12, 13 auf einer ersten Seite 32 des Randbereichs 12 direkt aneinander grenzen und auf einer der ersten Seite 32 gegenüberliegenden zweiten Seite 33 des ersten Randbereichs 12 durch die Falzung 14 unter Zwischenschaltung des Dichtelements 30 aneinander grenzen. Die Randbereiche 12, 13 sind dabei - zumindest leicht - federelastisch ausgebildet, wodurch der jeweils eine Randbereich 12, 13 unter Vorspannung den jeweils anderen Randbereiche 12, 13 mit Druck beaufschlagt.

Die Figur 6 zeigt das Gehäuse 6 der Figuren 4 und 5, wobei die Randbereiche 12, 13 gegenüber der in Figur 5 gezeigten Situation zusätzlich auch einmal miteinander gefalzt sind. Somit ist der Randbereich 13 einmal um den Randbereich 12 herumgefalzt und anschließend die beiden Randbereiche 12, 13 noch einmal miteinander gefalzt. Durch diese Kombination ergibt sich eine erhöhte Vorspannung, wodurch ein hoher Druck auf das Dichtelement 30 wirkt, sodass dieses das Gehäuse 6 beim Schließen dichtet. Die Falzungen der Figuren 5 und 6 werden durch ein umlaufendes Bördeln erstellt, bei dem der Randbereich 12, 13 beziehungsweise die Randbereiche 12, 13 durch das Umlaufen einer geeignet geformten Rolle in einem Bearbeitungsschritt (Figur 5) beziehungsweise in zwei Bearbeitungsschritten (Figur 6) umgebogen wird/werden, wobei das Dichtelement 30 in der Mitte des entstehenden Bördelrandes unter konstantem Druck steht.

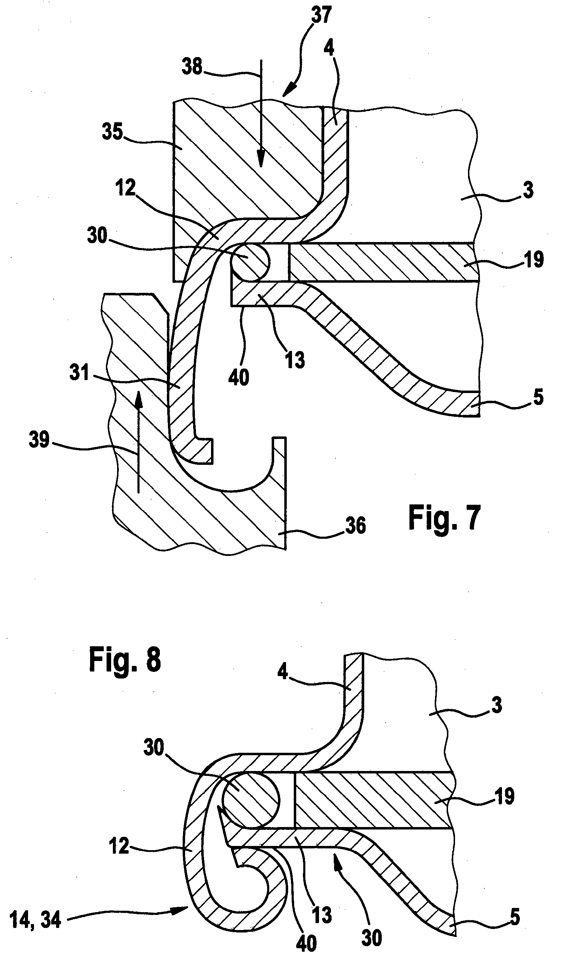

Alternativ zu dem Erstellen der Falzung 14 als umlaufender Bördelrand wird die Falzung als eine in Figur 8 gezeigte Rollung 34 erstellt. Die Figur 7 zeigt die Randbereiche 12, 13 der Gehäuseelemente 4,5 beim Erstellen der als Rollung 34 ausgebildeten Falzung 14. Die beiden Gehäuseelemente 4, 5 werden so aneinander angesetzt, dass sie mit ihren Randbereichen 12, 13 ein Dichtelement 30 und einen Randbereich des Substrats 19 halten. Nach dem Ansetzen wird das zusammengesetzte Steuergerät 1 in eine Presse eingelegt. Beim Schließen der nicht gezeigten Presse werden die beiden Gehäuseelemente 4, 5 durch einen Federboden zusammengedrückt und fixiert (Figur 7). Anschließend fahren zwei Elemente 35, 36 (Halteelement 35 und Formelement 36) eines zweiten, formgebenden Werkzeugs 37 zusammen (Pfeile 38, 39), wobei das Formelement 36 umlaufend um das Steuergerät 1 gleichzeitig den gegenüber dem Randbereich 13 gegenüberstehenden Teilbereich 31 des Randbereichs 12 einrollt und gegen die dem Gehäuseelement 4 und dem Dichtelement 30 abgewandte Seite 40 des Randbereichs 13 des Gehäuseelements 5 drückt. Dies hat den Vorteil, dass das Werkzeug nur in eine Raumrichtung bewegt werden muss, wobei durch das Halteelement 35 des Werkzeugs 37 Störkonturen des Steuergeräts 1 ausgenommen werden können, ohne die Dichtheit des Steuergerätes 1 zu beeinflussen. Es ergibt sich ein umlaufender, metallischer Kontakt der Gehäuseelemente 4, 5. Dadurch wird eine optimale Abschirmung der elektrischen Schaltung 2 im Gehäuse 6 bezüglich elektromagnetischer Strahlung erreicht. Der Prozess des simultanen Einrollens kann - mehr oder weniger - das Einrollen der abgerundeten Ecken des Steuergerätes 1 ausnehmen. Dazu ist der Teilbereich 31 des Randbereichs 12 an den Ecken weniger hoch als auf den Kanten des Gehäuses 6. Im Extremfall wird das Gehäuse 6 nur auf den geraden Kanten eingerollt und damit verschlossen.

Die Figur 8 zeigt das durch die Rollung 34 geschlossene Gehäuse 6. Zwischen den Gehäuseelementen 4,5 ist das als Silikondichtung ausgebildete Dichtelement 30 und das Substrat 19 der elektrischen Schaltung 2 angeordnet. Der Randbereich 12 des als Gehäusedeckel ausgebildeten Gehäuseelements 4 ist länger ausgebildet als der Randbereich 13 des als Gehäuseboden ausgebildeten Gehäuseelements 5 und wird um das Dichtelement 30, das Substrat 19 und den Randbereich 13 herumgebogen und auf der gegenüberliegenden Seite 40 eingerollt.

Es ergeben sich folgende vorteilhafte Ausgestaltungen des Gehäuses 6: Zur Reparatur oder Wiederinstandsetzung des Steuergerätes 1 kann die Falzung 14 des Gehäuses 6 abgestanzt werden und so die Gehäuseelemente 4, 5 geöffnet werden. Nach der Reparatur der elektrischen Schaltung 2 wird diese in ein neues Gehäuse 6 montiert.

Zusätzlich zu der Befestigungsmöglichkeit des Steuergeräts 1 durch Schrauben des Montageelements 8 an die Karosserie des Fahrzeugs, weist das Gehäuse 6 im Bereich des Montageelements 8 Einpressstrukturen auf. Diese ermöglichen ein Befestigen des Gehäuseelements 5 am Montageelement 8 durch Toxen oder Nieten. Der Gehäuseboden 5 weist dazu versteifte Öffnungen auf. Das Gehäuse 6 dichtet durch Eindrücken des Montageelements 8. Alternativ oder zusätzlich weist der Gehäuseboden 5 die Nietdome 9 oder Montagemulden auf. Das Montageelement 8 besitzt Ansaugöffnungen in den Einpressstrukturen und wird durch Ansaugen in die Mulden 24 des Gehäusebodens gezogen. Insbesondere ist vorgesehen, dass in den Einpressstrukturen Druckausgleichselemente angeordnet sind. Eine Membran des Druckausgleichselements ist zwischen dem Gehäuseboden 5 und dem, Montageelement 8 in der Einpressstruktur eingeklemmt. Dabei kann mindestens ein Montageteil eine Membran eines Druckausgleichselements (DAE) aufnehmen.

Weiterhin kann mindestens eines der Gehäuseelemente 4, 5 als isoliertes Metallsubstrat (IMS) ausgebildet sein. Einfache Schaltungsstrukturen einer elektrischen Schaltung sind damit auf dem Gehäuse 6 aufgebracht. Wenn die Gehäuseelemente 4, 5 des Gehäuses 6 beide als Träger für elektrische Schaltungen verwendet werden, werden die entsprechenden elektrischen Schaltungen durch eine geeignete elektrische Verbindung, wie zum Beispiel ein Flachbandkabel oder eine FPC (Flexibel Printed Circuit), welche auch Bauelemente tragen kann, verbunden. Dabei kann das Substrat 19 entfallen oder zusätzlich integriert sein.

Alternativ kann die Schaltungsstruktur der elektrischen Schaltung 2 auf einem isolierten Metallsubstrat in einem der Gehäuseelemente 4, 5 auch über Kontaktstellen auf dem isolierten Metallsubstrat des anderen Gehäuseelements 4, 5 an der Klemmzone 20 verbunden werden, sodass beim Verpressen der Gehäuseelemente 4, 5 die Kontaktelemente elektrisch verbunden werden. Ebenfalls ist eine elektrische Verbindung vom isolierten Metallsubstrat auf das Substrat 19 vorgesehen, wobei die Verbindung im Bereich der Klemmzone 20 des Substrats 19 erfolgt. Dabei verfügen das isolierte Metallsubstrat und das Substrat 19 an den Verbindungsstellen über ein gleiches Leiterbahnmuster, wobei beim Verpressen des Substrats 19 mit den Gehäuseelementen 4, 5 die Kontaktelemente auf dem Substrat und auf dem isolierten Metallsubstrat miteinander verpresst werden. Dazu werden insbesondere Kontaktmittel (zum Beispiel Leitkleber) verwendet. Als weiteres Variante kann ein FPC auf einem der Gehäuseelemente 4, 5 auflaminiert werden. Der Außenanschluss für das Steuergerät 1 wird durch die Steckerleiste 16 gebildet, die auf dem Substrat 19 oder auf das Gehäuse 6 direkt montiert ist. Wenn eines der Gehäuseelemente 4, 5 als isoliertes Metallsubstrat ausgebildet ist, sind im Außenanschlussbereich insbesondere Kontaktbahnen vorgesehen, welche durch den Gegenstecker kontaktiert werden. Als Variante ist das Steuergerät 1 mit einem oder mehreren Kabelanschlüssen versehen. Dabei wird das Gehäuse 6 im Bereich der Kabeldurchführungen um mindestens ein Kabel verpresst. Alternativ kann eine Kabeldurchführung, die dicht mit dem Kabelmantel verbunden ist, in eine Öffnung im Gehäuse 6 gepresst werden.

## Patentansprüche

1. Gehäuse für eine elektrische Schaltung, insbesondere für ein Steuergerät eines Fahrzeugs, mit mindestens einem, einen die Schaltung aufnehmenden Innenraum aufweisenden Gehäuseelement, das mindestens einen dem Schließen des Gehäuses dienenden Randbereich aufweist, wobei der Randbereich des Gehäuses (6) mit mindestens einer, ein Schließen des Gehäuses (6) herbeiführenden Falzung (14,29) versehen ist, wobei mindestens zwei Gehäuseelemente (4,5) jeweils mit mindestens einem Randbereich (12,13) versehen sind, wobei die Randbereiche (12,13) mindestens bereichsweise aneinander grenzen und mindestens einer der Randbereiche (12,13) mit mindestens einer ein Schließen des Gehäuses (6) herbeiführenden Falzung (14,29) versehen ist, **dadurch gekennzeichnet, dass** die Randbereiche mindestens bereichsweise unter Zwischenschaltung mindestens eines Dichtelements (30) aneinander grenzen, wobei einer der Randbereiche (13) um den anderen der Randbereiche (12) zumindest bereichsweise zumindest einmal herumgefalzt ist, sodass das Dichtelement (30) zwischen dem umgefalzten Teil des einen Randbereichs (13) und dem anderen Randbereich (12) liegt, und wobei die beiden Randbereiche (12,13) mindestens bereichsweise mindestens einmal miteinander gefalzt sind, um die Falzung (14,29) als umlaufenden Bördelrand zu bilden.

2. Gehäuse nach Anspruch 1, **dadurch gekennzeichnet, dass** die beiden umgefalzten Randbereiche (12,13) unterschiedlich lang ausgebildet sind.

3. Gehäuse nach einem der vorhergehenden Ansprüche, **dadurch gekennzeichnet, dass** die Falzung (14) als Rollung (34) ausgebildet ist oder mindestens eine Rollung (34) aufweist.

4. Gehäuse nach einem der vorhergehenden Ansprüche, **dadurch gekennzeichnet, dass** mindestens einer der Randbereiche (12,13) federelastisch ausgebildet ist.

5. Gehäuse nach einem der vorhergehenden Ansprüche, **dadurch gekennzeichnet, dass** mindestens einer der Randbereiche (12,13) unter Vorspannung den anderen Randbereich (12,13) beaufschlagt.

6. Gehäuse nach einem der vorhergehenden Ansprüche, **dadurch gekennzeichnet, dass** die elektrische Schaltung (2), insbesondere ein Substrat (19) der elektrischen Schaltung (2), von mindestens einem Randbereich (12,13) gehalten ist.

7. Verfahren zum Schließen eines Gehäuses für eine elektrische Schaltung, insbesondere für das Gehäuse eines Steuergeräts eines Fahrzeugs, wobei das Gehäuse einen die Schaltung aufnehmenden Innenraum aufweist und mindestens einen Randbereich besitzt und der Randbereich des Gehäuses zum Schließen des Gehäuses mindestens einmal gefalzt wird, wobei mindestens zwei Gehäuseelemente jeweils mit mindestens einem Randbereich versehen sind, wobei die Randbereiche mindestens bereichsweise aneinander grenzen und mindestens einer der Randbereiche zum Schließen des Gehäuses gefalzt wird, **dadurch gekennzeichnet, dass** einer der Randbereiche um den anderen der Randbereiche und ein Dichtelement zumindest einmal herumgefalzt wird und die Randbereiche anschließend mindestens bereichsweise mindestens einmal miteinander gefalzt werden, wobei das Falzen durch ein umlaufendes Bördeln erfolgt.

## Claims

1. Housing for an electrical circuit, in particular for a controller of a vehicle, having at least one housing element which has an interior space which accommodates the circuit and which has at least one edge region which serves to close the housing, wherein the edge region of the housing (6) is provided with at least one fold (14, 29) which causes the housing (6) to close, wherein at least two housing elements (4, 5) are each provided with at least one edge region (12, 13), wherein the edge regions (12, 13) border one another at least in regions and at least one of the edge regions (12, 13) is provided with at least one fold (14, 29) which causes the housing (6) to close, **characterized in that** the edge regions border one another at least in regions with the interposition of at least one sealing element (30), wherein one of the edge regions (13) is folded around the other of the edge regions (12) at least once at least in regions, so that the sealing element (30) is situated between the folded-over part of the one edge region (13) and the other edge region (12), and wherein the two edge regions (12, 13) are folded together at least once at least in regions in order to form the fold (14, 29) as a circumferential beaded edge.

2. Housing according to Claim 1, **characterized in that** the two folded-over edge regions (12, 13) have different lengths.

3. Housing according to either of the preceding claims, **characterized in that** the fold (14) is in the form of a rolled portion (34) or has at least one rolled portion (34).

4. Housing according to one of the preceding claims, **characterized in that** at least one of the edge regions (12, 13) is spring-elastic.

5. Housing according to one of the preceding claims, **characterized in that** at least one of the edge regions (12, 13) acts on the other edge region (12, 13) under prestress.

6. Housing according to one of the preceding claims, **characterized in that** the electrical circuit (2), in particular a substrate (19) of the electrical circuit (2), is held by at least one edge region (12, 13).

7. Method for closing a housing for an electrical circuit, in particular for the housing of a controller of a vehicle, wherein the housing has an interior space which accommodates the circuit and has at least one edge region and the edge region of the housing is folded at least once in order to close the housing, wherein at least two housing elements are each provided with at least one edge region, wherein the edge regions border one another at least in regions and at least one of the edge regions is folded in order to close the housing, **characterized in that** one of the edge regions is folded around the other of the edge regions and a sealing element at least once and the edge regions are then folded together at least once at least in regions, wherein folding is performed by a circumferential beading.

## Revendications

1. Boîtier pour un circuit électrique, en particulier pour un appareil de commande d'un véhicule, comportant au moins un élément de boîtier comprenant un espace intérieur recevant le circuit, lequel élément de boîtier comprend au moins une région de bord servant à la fermeture du boîtier, la région de bord du boîtier (6) étant pourvue d'au moins un pli (14, 29) provoquant la fermeture du boîtier (6), au moins deux éléments de boîtier (4, 5) étant respectivement pourvus d'au moins une région de bord (12, 13), les régions de bord (12, 13) étant adjacentes les unes aux autres au moins dans certaines régions et au moins l'une des régions de bord (12, 13) étant pourvue d'au moins un pli (14, 29) provoquant une fermeture du boîtier (6), **caractérisé en ce que** les régions de bord sont adjacentes les unes aux autres au moins dans certaines régions par l'intermédiaire d'au moins un élément d'étanchéité (30), l'une des régions de bord (13) étant pliée au moins une fois et au moins dans certaines régions autour de l'autre des régions de bord (12), de telle sorte que l'élément d'étanchéité (30) se situe entre la partie repliée de l'une des régions de bord (13) et l'autre région de bord (12), et les deux régions de bord (12, 13) étant pliées l'une avec l'autre au moins une fois et au moins dans certaines régions, afin de former le pli (14, 29) sous forme de bord rabattu périphérique.

2. Boîtier selon la revendication 1, **caractérisé en ce que** les deux régions de bord (12, 13) repliées sont de longueurs différentes.

3. Boîtier selon l'une quelconque des revendications précédentes, **caractérisé en ce que** le pli (14) est réalisé sous forme d'enroulement (34) ou comprend au moins un enroulement (34).

4. Boîtier selon l'une quelconque des revendications précédentes, **caractérisé en ce qu'**au moins l'une des régions de bord (12, 13) est réalisée de manière élastique.

5. Boîtier selon l'une quelconque des revendications précédentes, **caractérisé en ce qu'**au moins l'une des régions de bord (12, 13) sollicite l'autre région de bord (12, 13) avec précontrainte.

6. Boîtier selon l'une quelconque des revendications précédentes, **caractérisé en ce que** le circuit électrique (2), en particulier un substrat (19) du circuit électrique (2), est supporté par au moins une région de bord (12, 13).

7. Procédé pour fermer un boîtier pour un circuit électrique, en particulier pour le boîtier d'un appareil de commande d'un véhicule, le boîtier comprenant un espace intérieur recevant le circuit et possédant au moins une région de bord et la région de bord du boîtier étant pliée au moins une fois pour fermer le boîtier, au moins deux éléments de boîtier étant respectivement pourvus d'au moins une région de bord, les régions de bord étant adjacentes les unes aux autres au moins dans certaines régions et au moins l'une des régions de bord étant pliée pour fermer le boîtier, **caractérisé en ce que** l'une des régions de bord est pliée au moins une fois autour de l'autre des régions de bord et d'un élément d'étanchéité, et les régions de bord sont ensuite pliées les unes avec les autres au moins une fois et au moins dans certaines régions, le pliage s'effectuant par un rabattage périphérique.
